# FASCICULE DE BREVET EUROPEEN

(11) **EP 3 401 958 B1**
(45) Date de publication et mention de la délivrance du brevet: **07.08.2019**
(21) Numéro de dépôt: 18170687.0
(22) Date de dépôt: 03.05.2018
(51) Int. Cl.: H01L 25/075, H01L 33/00, H01L 27/15, H01L 25/16, H01L 33/62

(54) **PROCÉDÉ DE FABRICATION D'UN DISPOSITIF D'AFFICHAGE ÉMISSIF À LED**
HERSTELLUNGSVERFAHREN EINER LED-ANZEIGEVORRICHTUNG
METHOD FOR MANUFACTURING AN LED EMISSIVE DISPLAY

(30) Priorité: 11.05.2017 FR 1754150
(43) Date de publication de la demande: 14.11.2018
(73) Titulaire: Commissariat à l'Energie Atomique et aux Energies Alternatives, 75015 Paris (FR)
(72) Inventeur: ROBIN, Ivan-Christophe, 38000 GRENOBLE (FR); BONO, Hubert, 38000 GRENOBLE (FR)
(74) Mandataire: Cabinet Beaumont

(56) Documents cités:
- FR-A1- 3 033 939
- US-A1- 2010 267 176
- US-A1- 2016 247 855
- US-A1- 2016 258 588

## Description

### Domaine

La présente demande concerne la réalisation d'un dispositif d'affichage d'images émissif à diodes électroluminescentes (LED), par exemple un écran de télévision, d'ordinateur, de smartphone, de tablette numérique, etc.

### Exposé de l'art antérieur

Il a déjà été proposé, dans la demande de brevet français n°1561421 déposée le 26 novembre 2015, un procédé de fabrication d'un dispositif d'affichage d'images comportant une pluralité de micropuces électroniques élémentaires disposées en matrice sur un même substrat de report. Selon ce procédé, les micropuces et le substrat de report sont fabriqués séparément. Chaque micropuce comprend un empilement d'une LED et d'un circuit de commande de la LED. Le circuit de commande comprend une face de connexion opposée à la LED, comprenant une pluralité de plages de connexion électrique destinées à être connectées au substrat de report pour la commande de la micropuce. Le substrat de report comprend une face de connexion comportant, pour chaque micropuce, une pluralité de plages de connexion électrique destinées à être connectées respectivement aux plages de connexion électrique de la micropuce. Les puces sont ensuite rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Il serait souhaitable de pouvoir améliorer au moins en partie certains aspects de ce procédé et/ou des dispositifs d'affichage réalisés par ce procédé.

### Résumé

Ainsi, un mode de réalisation prévoit un procédé de fabrication de puces élémentaires d'un dispositif d'affichage émissif à LED, chaque puce comprenant une LED semiconductrice inorganique, un circuit de commande de la LED, et une pluralité de plages de connexion à un dispositif extérieur disposées sur une face de connexion de la puce, le procédé comportant les étapes suivantes :
a) former les circuits de commande des puces dans et sur un substrat semiconducteur de façon que chaque circuit de commande comporte un plot de contact du côté d'une première face du substrat ;
b) rapporter sur la première face du substrat un empilement de LED comportant au moins des première et deuxième couches semiconductrices de types de conductivité opposés, de façon que la deuxième couche de l'empilement soit électriquement connectée aux plots de contact des circuits de commande ;
c) former dans chaque puce une tranchée périphérique entourant, en vue de dessus, le circuit de commande et la LED de la puce, la tranchée périphérique s'étendant verticalement dans le substrat sur toute la hauteur du circuit de commande, traversant la deuxième couche semiconductrice de l'empilement de LED, et pénétrant au moins partiellement dans la première couche semiconductrice de l'empilement de LED ;
d) former dans chaque tranchée une métallisation annulaire en contact avec la première couche semiconductrice de l'empilement de LED sur toute la longueur de la tranchée ; et
e) découper le substrat et l'empilement de LED dans des chemins de découpe situés, en vue de dessus, à l'extérieur des tranchées périphériques des puces de façon à individualiser les puces.

Selon un mode de réalisation, dans chaque puce :
la face de la métallisation annulaire opposée à la première couche semiconductrice de l'empilement de LED débouche sur une deuxième face du substrat opposée à la première face et définit une première plage de connexion de la puce ; et
au moins une deuxième plage de connexion électrique connectée au circuit de commande de la puce est formée sur la deuxième face du substrat.

Selon un mode de réalisation, les tranchées sont formées à partir de la deuxième face du substrat, après la formation de ladite au moins une deuxième plage de connexion électrique.

Selon un mode de réalisation, les tranchées traversent entièrement le substrat et la deuxième couche semiconductrice de l'empilement de LED, et s'interrompent dans la première couche semiconductrice de l'empilement de LED.

Selon un mode de réalisation, le procédé comprend, entre l'étape c) et l'étape d), une étape de dépôt conforme d'une couche isolante sur les parois latérales et sur le fond des tranchées, et une étape de retrait de ladite couche isolante au fond des tranchées pour libérer l'accès à la première couche semiconductrice de l'empilement de LED.

Selon un mode de réalisation, les tranchées sont formées à partir de la face de l'empilement de LED opposée au substrat, avant la formation de ladite au moins une deuxième plage de connexion électrique.

Selon un mode de réalisation, les tranchées traversent entièrement l'empilement de LED, et pénètrent dans le substrat sur une profondeur supérieure ou égale à l'épaisseur du circuit de commande.

Selon un mode de réalisation, le procédé comprend, entre l'étape c) et l'étape d), une étape de dépôt conforme d'une couche isolante sur les parois latérales et sur le fond des tranchées, et une étape de retrait de ladite couche isolante sur une partie supérieure des parois latérales des tranchées, pour libérer l'accès à la première couche semiconductrice de l'empilement de LED.

Selon un mode de réalisation, le procédé comprend en outre, avant l'étape a), une étape de dépôt d'une première couche métallique s'étendant de façon continue sur sensiblement toute la première face du substrat, et une étape de dépôt d'une deuxième couche métallique s'étendant de façon continue sur sensiblement toute la surface de la deuxième couche semiconductrice de l'empilement de LED opposée à la première couche semiconductrice dudit empilement.

Selon un mode de réalisation, à l'étape b), la fixation de l'empilement de LED sur le substrat est réalisée par collage direct de la première couche métallique sur la deuxième couche métallique.

Un autre mode de réalisation prévoit un procédé de fabrication d'un dispositif d'affichage émissif à LED, comprenant les étapes suivantes :
réaliser une pluralité de puces élémentaires par un procédé tel que défini ci-dessus ;
réaliser un substrat de report comprenant, pour chaque puce, sur une face de connexion du substrat de report, une pluralité de plages de connexion destinées à être connectées respectivement aux plages de connexion de la puce ; et
fixer les puces sur le substrat de report de façon à connecter électriquement les plages de connexion des puces sur les plages de connexion correspondantes du substrat de report.

Selon un mode de réalisation, à l'issue de l'étape e), les puces sont disposées sur un substrat de support selon un pas inter-puces inférieur au pas inter-puces du dispositif d'affichage final ; et
seule une partie des puces du substrat de support sont fixées au substrat de report au pas du dispositif d'affichage final et sont sélectivement détachées du substrat de support.

Un autre mode de réalisation prévoit une puce élémentaire d'un dispositif d'affichage émissif à LED, comprenant une LED semiconductrice inorganique, un circuit de commande de la LED, et une pluralité de plages de connexion à un dispositif extérieur, dans laquelle :
le circuit de commande est formé dans et sur un substrat semiconducteur et comprend un plot de contact du côté d'une première face du substrat ;
la LED est formée dans un empilement de LED comportant au moins des première et deuxième couches semiconductrices de types de conductivité opposés, la deuxième couche de l'empilement étant électriquement connectée au plot de contact du circuit de commande ;
au moins une tranchée périphérique entoure, en vue de dessus, le circuit de commande et la LED de la puce, la tranchée annulaire s'étendant verticalement sur toute la hauteur du circuit de commande, traversant la deuxième couche semiconductrice et pénétrant au moins partiellement dans la première couche semiconductrice de l'empilement de LED ; et
une métallisation annulaire disposée dans la tranchée annulaire est en contact avec la première couche semiconductrice de l'empilement de LED sur toute la longueur de la tranchée.

Selon un mode de réalisation, un empilement de première et deuxième couches métalliques s'étendant sur sensiblement toute la surface du circuit de commande fait interface entre le circuit de commande et la LED de la puce.

Un autre mode de réalisation prévoit un dispositif d'affichage émissif à LED comprenant :
une pluralité de puces élémentaires telles que définies ci-dessus ; et
un substrat de report comprenant, pour chaque puce, sur une face de connexion du substrat de report, une pluralité de plages de connexion connectées respectivement aux plages de connexion de la puce.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe illustrant de façon schématique une étape de report d'une micropuce sur un substrat de report, selon un exemple d'un procédé de fabrication d'un dispositif d'affichage émissif à LED ;
les figures 2A, 2B, 2C, 2D, 2E, 2F, 2G, 2H, 2I, 2J, 2K, 2L et 2M sont des vues en coupe illustrant des étapes d'un exemple d'un procédé de fabrication de micropuces élémentaires d'un dispositif d'affichage émissif à LED selon un mode de réalisation ;
les figures 3A et 3B sont des vues en coupe illustrant des étapes d'un exemple d'un procédé de fabrication d'un dispositif d'affichage émissif à LED à base de micropuces réalisées par le procédé des figures 2A à 2M ;
les figures 4A, 4B, 4C, 4D, 4E et 4F sont des vues en coupe illustrant des étapes d'un autre exemple d'un procédé de fabrication de micropuces élémentaires d'un dispositif d'affichage émissif à LED selon un mode de réalisation ;
la figure 5 est une vue en coupe illustrant plus en détail une étape du procédé des figures 2A à 2M ; et
la figure 6 est une vue en coupe illustrant plus en détail une étape du procédé des figures 4A à 4F.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la fabrication des LED et des circuits de commande des micropuces élémentaires, et du substrat de report des dispositifs d'affichage décrits n'a pas été détaillée, la fabrication de ces éléments étant à la portée de l'homme du métier à partir des enseignements de la présente description.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures correspondantes, étant entendu que, dans la pratique, les dispositifs décrits peuvent être orientés différemment. Sauf précision contraire, les expressions "approximativement", "sensiblement", et "de l'ordre de" signifient à 10 % près, de préférence à 5 % près.

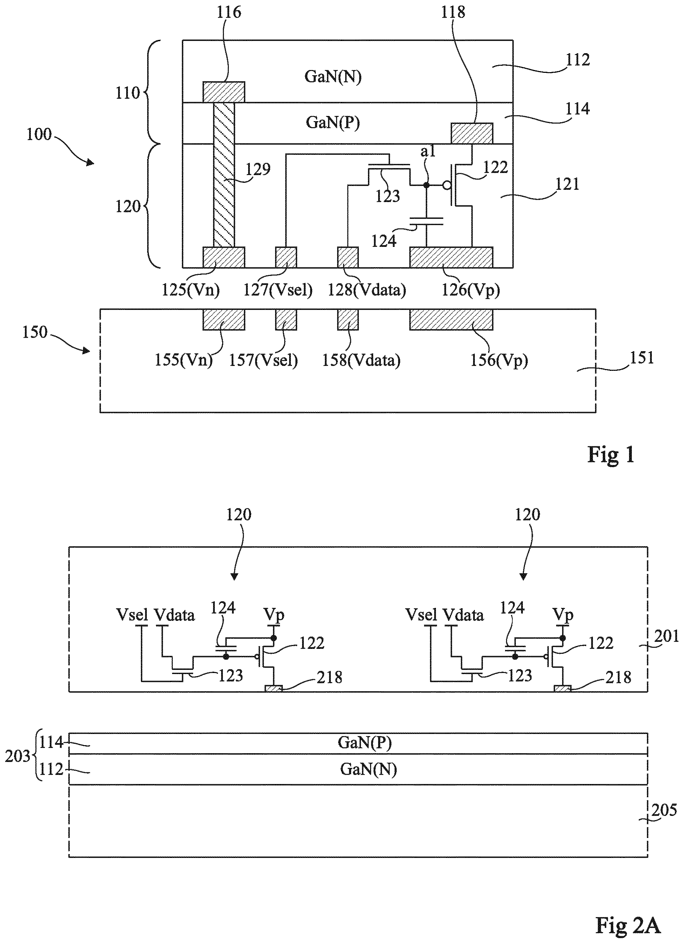

La figure 1 est une vue en coupe illustrant de façon schématique et partielle une étape de report d'une micropuce 100 sur un substrat de report 150, selon un exemple d'un procédé de fabrication d'un dispositif d'affichage émissif à LED.

La figure 1 représente plus particulièrement la micropuce 100 et le substrat de report 150 avant l'étape proprement dite de fixation de la micropuce sur le substrat de report.

En pratique, un dispositif d'affichage peut comporter une pluralité de puces élémentaires 100 identiques ou similaires montées sur un même substrat de report selon un agencement en matrice selon des lignes et des colonnes, les puces étant connectées à des éléments de connexion électrique du substrat pour leur commande, et chaque micropuce correspondant par exemple à un pixel du dispositif d'affichage.

La micropuce 100 comprend, dans une portion supérieure, une LED semiconductrice inorganique 110, et, dans une portion inférieure solidaire de la portion supérieure, un circuit de commande actif 120 formé dans et sur un substrat semiconducteur, par exemple en silicium monocristallin, adapté à contrôler l'émission de lumière par la LED.

La LED 110 comprend au moins une homojonction ou une hétérojonction, par exemple une jonction PN formée d'un empilement d'une couche semiconductrice supérieure de type N 112 et d'une couche semiconductrice inférieure de type P 114, et deux contacts électriques 116 et 118, respectivement sur la couche 112 et sur la couche 114, pour injecter un courant électrique au travers de l'empilement, afin de produire de la lumière. A titre d'exemple, la LED 110 est une LED au nitrure de gallium (GaN) ou à base de tout autre semiconducteur III-V adapté.

Le circuit de commande 120 est réalisé dans et sur un substrat semiconducteur 121, par exemple un bloc de silicium monocristallin, et comprend des composants électroniques, et notamment un ou plusieurs transistors et au moins un élément capacitif de maintien d'un signal de polarisation, pour la commande individuelle de la LED 110. La face supérieure du circuit de commande 120 est en contact mécaniquement et électriquement avec la LED 110. La face inférieure du circuit 120, définissant une face de connexion de la micropuce, comprend une pluralité de plages de connexion électrique destinées à être connectées à des plages de connexion électrique correspondantes du substrat de report 150 pour la commande de la micropuce. Dans l'exemple représenté, la face inférieure du circuit 120 comprend quatre plages de connexion électrique 125, 126, 127 et 128. Les plages 125 et 126 sont destinées à recevoir respectivement un potentiel d'alimentation bas (par exemple la masse) Vn et un potentiel d'alimentation haut (c'est-à-dire supérieur au potentiel d'alimentation bas) Vp de la micropuce. Les plages 127 et 128 sont destinées à recevoir des signaux de commande de la micropuce. Plus particulièrement, la plage 127 est destinée à recevoir un signal Vsel de sélection de la micropuce, et la plage 128 est destinée à recevoir un signal Vdata de réglage du niveau de luminosité de la micropuce. Les plages de connexion 125, 126, 127 et 128 sont par exemple en métal, par exemple en cuivre. Dans cet exemple, le circuit de commande 120 comprend deux transistors MOS 122 et 123 et un élément capacitif 124, par exemple un condensateur. Le transistor 122, par exemple un transistor à canal P, a un premier noeud de conduction (source ou drain) connecté à la plage de connexion 126 (Vp) de la micropuce, un deuxième noeud de conduction (drain ou source) connecté à la borne de contact d'anode 118 de la LED 110, et un noeud de commande (grille) connecté à un noeud intermédiaire a1 du circuit 120. L'élément capacitif 124 a une première électrode connectée au noeud a1 et une deuxième électrode connectée à la plage de connexion 126 (Vp) de la micropuce. Le transistor 123, par exemple un transistor à canal N, a un premier noeud de conduction connecté à la plage de connexion 128 (Vdata) de la micropuce, un deuxième noeud de conduction connecté au noeud a1, et un noeud de commande connecté à la plage de connexion 127 (Vsel) de la micropuce. La micropuce 100 comprend en outre un via conducteur isolé 129 connectant la plage de connexion électrique 125 (Vn) de la micropuce à la borne de contact de cathode 116 de la LED 110.

Le fonctionnement de la micropuce élémentaire 100 lors d'une phase de mise à jour du niveau de luminosité du pixel est le suivant. Le transistor 123 est fermé (rendu passant) par l'application d'un signal de commande adapté sur la borne 127 (Vsel). L'élément capacitif 124 se charge alors à un niveau de tension fonction du signal de réglage appliqué sur la borne 128 (Vdata) de la micropuce. Le niveau du signal de réglage Vdata fixe le potentiel du noeud a1, et par conséquent l'intensité du courant injecté dans la LED par le transistor 122, et donc l'intensité lumineuse émise par la LED. Le transistor 123 peut ensuite être rouvert. Le noeud a1 reste alors à un potentiel sensiblement égal au potentiel Vdata. Ainsi, le courant injecté dans la LED reste sensiblement constant après la réouverture du transistor 123, et ce jusqu'à la prochaine mise à jour du potentiel du noeud a1.

Le substrat de report 150 comprend par exemple une plaque ou une feuille de support 151 en un matériau isolant, sur laquelle sont disposés des éléments de connexion électrique, par exemple des pistes et plages conductrices. Le substrat de report 150 est par exemple un substrat passif, c'est-à-dire qu'il comprend uniquement des éléments de connexion électrique pour l'amenée des signaux de commande et d'alimentation des micropuces. Le substrat de report 150 comprend une face de connexion, sa face supérieure dans l'exemple représenté, destinée à recevoir les micropuces 100. Pour chaque micropuce du dispositif d'affichage, le substrat de report 150 comprend, sur sa face de connexion, une pluralité de plages de connexion électrique (une par plage de connexion électrique de la micropuce) destinées à être connectées respectivement aux plages de connexion électrique de la micropuce. Ainsi, dans cet exemple, pour chaque micropuce 100 du dispositif d'affichage, le substrat de report 150 comprend quatre plages de connexion électrique 155, 156, 157 et 158 destinées à être connectées respectivement aux plages de connexion électrique 125, 126, 127 et 128 de la micropuce 100, pour l'amenée des signaux de commande Vn, Vp, Vsel et Vdata de la micropuce. Les plages de connexion électrique 155, 156, 157 et 158 du substrat de report sont par exemple en le même matériau conducteur que les plages de connexion électrique 125, 126, 127 et 128 des micropuces, par exemple du cuivre.

Lors du report de la micropuce 100 sur le substrat de report 150, la face de connexion de la micropuce est mise en contact avec la face de connexion du substrat de report de façon à connecter électriquement les plages de connexion électrique 125, 126, 127 et 128 de la micropuce respectivement aux plages de connexion électrique correspondantes 155, 156, 157 et 158 du substrat de report. La fixation de la micropuce 100 sur le substrat de report est par exemple réalisée par collage direct, c'est-à-dire sans apport de matière adhésive ou de brasure à l'interface entre la micropuce et le substrat.

Les figures 2A à 2M sont des vues en coupe illustrant des étapes successives d'un exemple d'un procédé de fabrication de micropuces élémentaires 200 d'un dispositif d'affichage émissif à LED selon un mode de réalisation. Les figures 2A à 2M représentent plus particulièrement la réalisation simultanée de deux micropuces voisines, étant entendu que, en pratique, le nombre de micropuces réalisées simultanément peut être bien plus élevé.

Les micropuces 200 réalisées par le procédé des figures 2A à 2M comprennent des éléments communs avec les micropuces 100 décrites en relation avec la figure 1. En particulier, comme les micropuces 100 de la figure 1, les micropuces 200 des figures 2A à 2M comprennent chacune une LED semiconductrice inorganique 110 et un circuit de commande actif 120 adapté à contrôler l'émission de lumière par la LED. Comme dans l'exemple de la figure 1, le circuit de commande 120 comprend une première face en contact mécaniquement et électriquement avec une face de la LED 110, et une deuxième face opposée à la première face, définissant une face de connexion de la micropuce, comportant des plages de connexion à un dispositif extérieur. Les éléments communs entre les micropuces 100 de la figure 1 et les micropuces 200 des figures 2A à 2M ne seront pas détaillés à nouveau.

La figure 2A illustre une étape de formation des circuits de commande 120 des micropuces 200 dans et sur un substrat semiconducteur 201, par exemple en silicium. A titre d'exemple, le substrat 201 est un substrat semiconducteur massif, ou un substrat de type semiconducteur sur isolant (SOI). Dans cet exemple, chaque circuit de commande élémentaire 120 comprend sensiblement les mêmes composants que dans l'exemple de la figure 1, agencés sensiblement de la même manière. Les transistors 122 et 123 et l'élément capacitif 124 de chaque circuit de commande 120 sont formés dans et sur le substrat 201, du côté d'une face du substrat 201 que l'on appellera ci-après la face avant du substrat. Dans chaque circuit de commande 120, au moins un plot de connexion électrique destiné à être connecté à la LED 110 de la micropuce est formé du côté de la face avant du substrat 201. Plus particulièrement, dans l'exemple représenté, chaque circuit de commande 120 comprend, du côté de la face avant du substrat 201, un plot de connexion électrique 218 connecté au noeud de conduction du transistor 122 non connecté à l'élément capacitif 124, destiné à être connecté à la LED 110. A titre d'exemple, les plots de connexion électrique 218 sont en métal et sont latéralement entourés par un matériau isolant, par exemple de l'oxyde de silicium, de façon que le circuit de contrôle 120 présente une face avant sensiblement plane. A ce stade, les plages de connexion à l'extérieur 125, 126, 127 et 128 des micropuces ne sont pas encore formées. Ces plages de connexion seront formées ultérieurement du côté de la face arrière du substrat 201.

La figure 2A illustre en outre une étape séparée de formation d'un empilement de LED inorganique 203 sur une face d'un substrat de croissance 205. Le substrat de croissance 205 est par exemple un substrat en saphir ou en silicium. A titre d'exemple, l'empilement 203 est un empilement de LED au nitrure de gallium, comportant, sur la face supérieure du substrat de croissance 205, une jonction PN formée d'un empilement d'une couche inférieure de nitrure de gallium de type N 112, et d'une couche supérieure de nitrure de gallium de type P 114. Plus généralement, tout autre empilement de LED inorganique, par exemple à base de semiconducteur III-V, peut être réalisé à cette étape sur la face supérieure du substrat de croissance 205. On notera en particulier que l'empilement 203 peut comporter une couche émissive non détaillée sur les figures, par exemple constituée d'un empilement d'une ou plusieurs couches émissives formant chacune un puits quantique, entre la couche de type N 112 et la couche de type P 114. L'empilement 203 est par exemple formé par épitaxie sur la face supérieure du substrat de croissance 205.

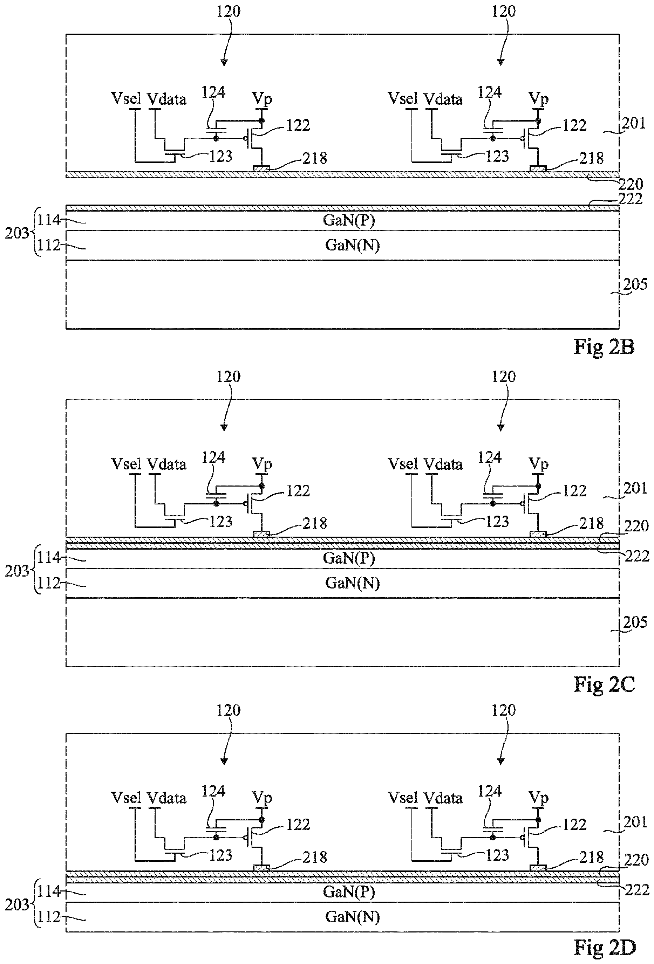

La figure 2B illustre une étape de dépôt, sur la face avant du substrat 201, d'une couche métallique 220. Dans l'exemple représenté, la couche métallique 220 revêt sensiblement toute la face avant du substrat 201. En particulier, la couche 220 revêt toute la face avant de chaque circuit de commande 120, et est en contact avec le plot de connexion 218 du circuit de commande.

La figure 2B illustre en outre une étape de dépôt, sur la face supérieure de l'empilement de LED 203, d'une couche métallique 222. Dans l'exemple représenté, la couche métallique 222 est disposée sur et en contact avec la face supérieure de la couche semiconductrice de type P 114 de l'empilement de LED 203. La couche métallique 222 revêt par exemple sensiblement toute la surface supérieure de l'empilement 203.

La figure 2C illustre une étape de report de l'empilement de LED 203 sur la face avant du substrat 201. Pour cela, la face de la couche métallique 220 opposée au substrat 201 est mise en contact avec la face de la couche métallique 222 opposée au substrat 205. Lors de cette étape, l'empilement de LED 203 est rendu solidaire des circuits de commande 120 formés dans et sur le substrat 201. De plus, la couche de type P 114 de l'empilement de LED 203 est connectée électriquement au plot de connexion 218 de chaque circuit de commande 120 par l'intermédiaire des couches métalliques 220 et 222. A titre d'exemple, la fixation de l'empilement de LED 203 sur le circuit substrat 201 peut être obtenue par collage direct entre les faces de contact des couches 220 et 222. Pour cela, les couches 220 et 222 sont de préférence de même nature, par exemple en cuivre, en titane, ou en aluminium. De plus, une étape de préparation des surfaces de contact des couches métalliques 220 et 222 peut être prévue préalablement au report, par exemple une étape de polissage mécano-chimique (CMP), de façon à obtenir une planéité suffisante, par exemple une rugosité inférieure à 1 nm, pour réaliser un collage direct entre les couches 220 et 222. Un recuit peut éventuellement être prévu après le collage, par exemple à une température comprise entre 150 et 250°C, pour augmenter la force du collage. A ce stade, l'empilement de LED 203 est un empilement continu (non divisé en LED individuelles) s'étendant sur sensiblement toute la surface du substrat semiconducteur 201.

La figure 2D illustre une étape de retrait du substrat de croissance 205 de l'empilement de LED 203. Dans le cas d'un substrat de croissance 205 en saphir, ce dernier peut par exemple être décollé de l'empilement 203 au moyen d'un faisceau laser projeté à travers le substrat 205 depuis sa face opposée à l'empilement 203. Dans le cas d'un substrat de croissance 205 en silicium, ce dernier peut par exemple être retiré par meulage et gravure, par exemple au moyen d'une solution de gravure à base d'hydroxyde de potassium, ou par gravure ionique réactive (RIE). Le retrait du substrat de croissance 205 conduit à libérer l'accès à la face inférieure de la couche semiconductrice de type N 112 de l'empilement de LED 203.

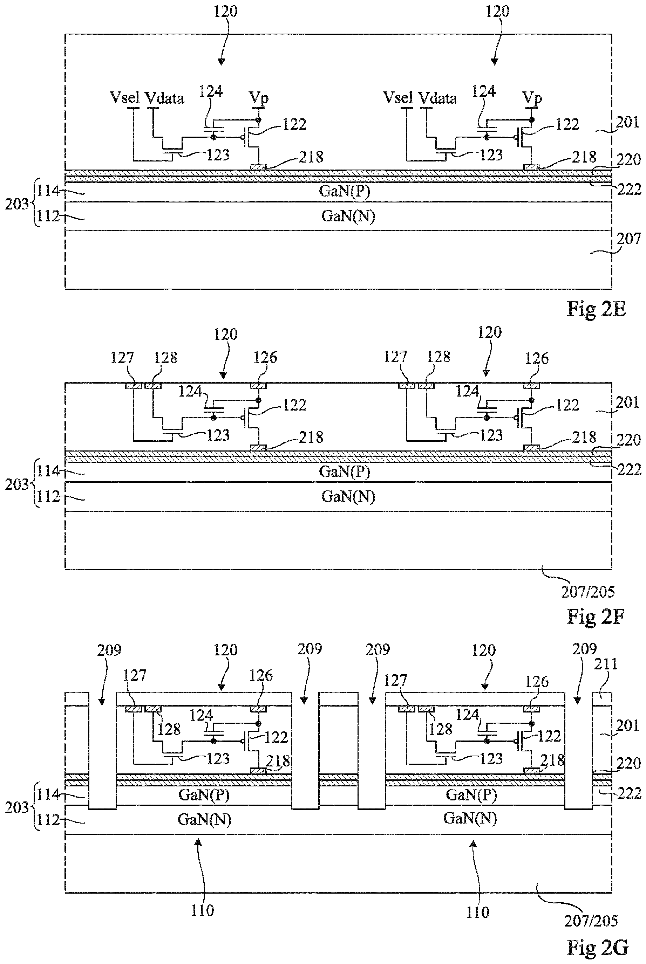

La figure 2E illustre une étape au cours de laquelle un substrat de support 207 est collé à la face inférieure de la couche semiconductrice de type N 112 de l'empilement de LED 203, en remplacement du substrat de croissance 205. Le substrat 207 est fixé à la couche 112 par un collage dit temporaire, présentant une énergie d'adhérence plus faible que la liaison initiale entre les micropuces et le substrat de croissance des LED, de façon à faciliter une étape ultérieure de prélèvement des micropuces. A titre d'exemple, le substrat de support 207 est un film adhésif transparent susceptible d'être décollé par irradiation UV.

A titre de variante, les étapes des figures 2D et 2E peuvent être omises, le substrat 205 de croissance de l'empilement de LED 203 étant alors utilisé comme substrat de support pour la suite du procédé.

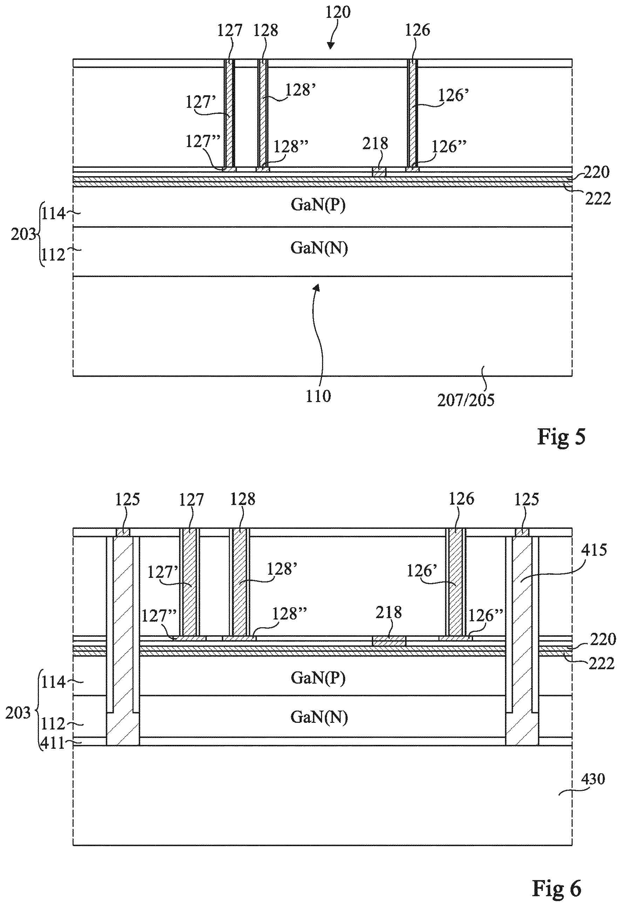

La figure 2F illustre une étape de formation de plages de connexion électrique des micropuces du côté de la face arrière du substrat 201. Lors de cette étape, seules sont formées, dans chaque micropuce, les plages de connexion de la micropuce contactant des composants du circuit de commande 120 de la micropuce, à savoir les plages de connexion 126, 127 et 128 en reprenant les références de la figure 1. En particulier, la plage de connexion électrique 125 contactant la couche semiconductrice de type N 112 de l'empilement de LED 203 n'est pas formée à cette étape. Le substrat 201 peut au préalable être aminci par sa face arrière, par exemple par meulage, de façon à faciliter l'accès aux composants des circuits de commande 120 à contacter. Les plages de connexion électrique 126, 127, 128 sont par exemple réalisées en métal, par exemple en cuivre. A titre d'exemple, les plages de connexion électrique 126, 127, 128 sont connectées aux composants des circuits de commande 120 par l'intermédiaire de vias conducteurs isolés 126', 127', 128' traversant entièrement le substrat 201 et contactant des métallisations 126'', 127'' et 128'' préalablement formées du côté de la face avant du substrat 201, comme l'illustre plus en détail la figure 5.

La figure 2G illustre une étape de formation, dans chaque micropuce, à partir de la face arrière du substrat 201, d'une tranchée périphérique annulaire 209, entourant entièrement, en vue de dessus, le circuit de commande 120 et la LED 110 de la micropuce. Chaque tranchée 209 s'étend verticalement depuis la face arrière du substrat 201, traverse entièrement le substrat 201, les couches métalliques 220 et 222, et la couche semiconductrice de type P 114 de l'empilement de LED 203, pénètre dans la couche semiconductrice de type N 112 et s'interrompt à un niveau intermédiaire entre la face supérieure et la face inférieure de la couche semiconductrice 112. Les tranchées 209 sont par exemple formées par gravure, par exemple par gravure ionique réactive à plasma à couplage inductif (RIE-ICP). Un masque de gravure 211, par exemple en oxyde de silicium est formé au préalable sur la face arrière du substrat 201 pour délimiter les zones de gravure.

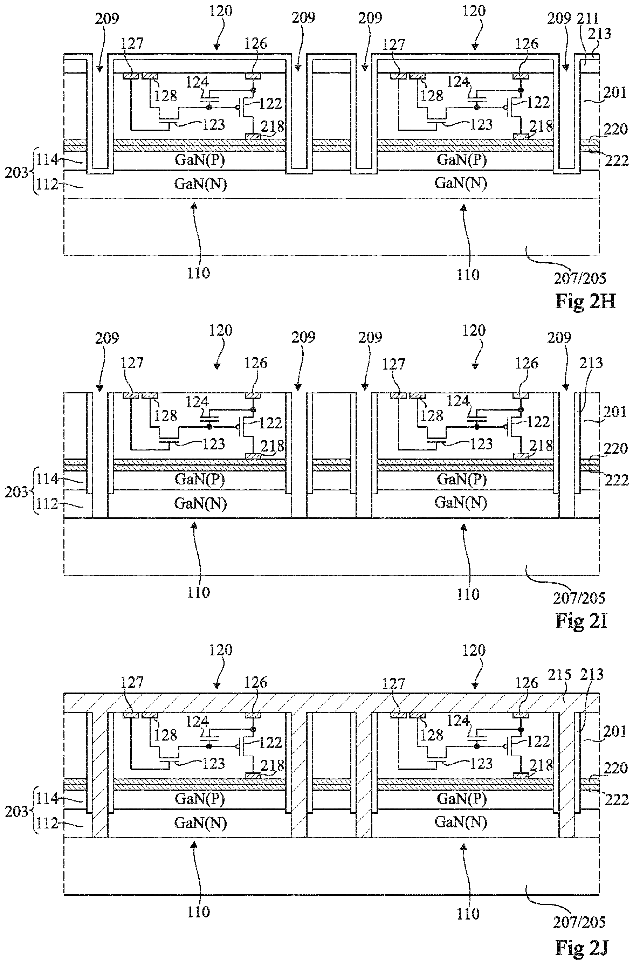

La figure 2H illustre une étape de dépôt conforme d'une couche électriquement isolante 213, par exemple une couche d'oxyde de silicium, sur les parois latérales et sur le fond des tranchées 209. Dans l'exemple représenté, la couche 213 est une couche continue s'étendant sur sensiblement toute la surface supérieure de la structure obtenue à l'issue de l'étape de la figure 2G. La couche 213 est par exemple formée par dépôt chimique en phase vapeur assisté par plasma (PECVD) ou par dépôt en couches monoatomiques successives (ALD).

La figure 2I illustre une étape de retrait de la couche isolante 213 au fond des tranchées 209, de façon à libérer l'accès à la couche semiconductrice inférieure 112 de l'empilement de LED 203. Lors de cette étape, la couche 213 est conservée sur les flancs des tranchées 209. A titre d'exemple, pour retirer la couche 213 au fond des tranchées 209 tout en la conservant sur les flancs des tranchées, une gravure directionnelle peut être mise en oeuvre, de façon à obtenir une vitesse de gravure dans la direction verticale nettement supérieure à la vitesse de gravure dans la direction horizontale (dans l'orientation de la figure 2I).

La figure 2I illustre en outre une étape de gravure de la couche semiconductrice 112 de l'empilement de LED 203 au fond des tranchées 209, par exemple par gravure ionique réactive à plasma à couplage inductif. Autrement dit, après le retrait de la couche isolante 213 au fond des tranchées 209, les tranchées 209 sont prolongées à travers la couche semiconductrice 112 de l'empilement de LED, jusqu'à la face supérieure du substrat de support 207 ou du substrat de croissance 205.

Le masque 211 préalablement déposé pour la formation des tranchées 209 peut ensuite être retiré, par exemple par gravure, de façon à libérer l'accès à la face supérieure des plages de connexion électrique 126, 127 et 128 des circuits de commande 120.

La figure 2J illustre une étape de remplissage des tranchées 209 par un métal conducteur, par exemple du cuivre. Dans l'exemple représenté, lors de cette étape, une couche métallique continue 215 est déposée sur toute la surface supérieure de l'assemblage, c'est-à-dire non seulement dans les tranchées 209, mais aussi sur la face arrière du substrat 201. A titre d'exemple, la formation de la couche 215 comprend une première étape de dépôt conforme d'une couche d'amorce de façon à prendre un contact électrique sur la couche semiconductrice inférieure 112 de l'empilement de LED, au niveau des parois latérales des prolongements des tranchées 209 réalisés à l'étape précédente, puis une deuxième étape de dépôt d'une couche métallique plus épaisse, par exemple un dépôt électrochimique de cuivre, de façon à remplir les tranchées 209.

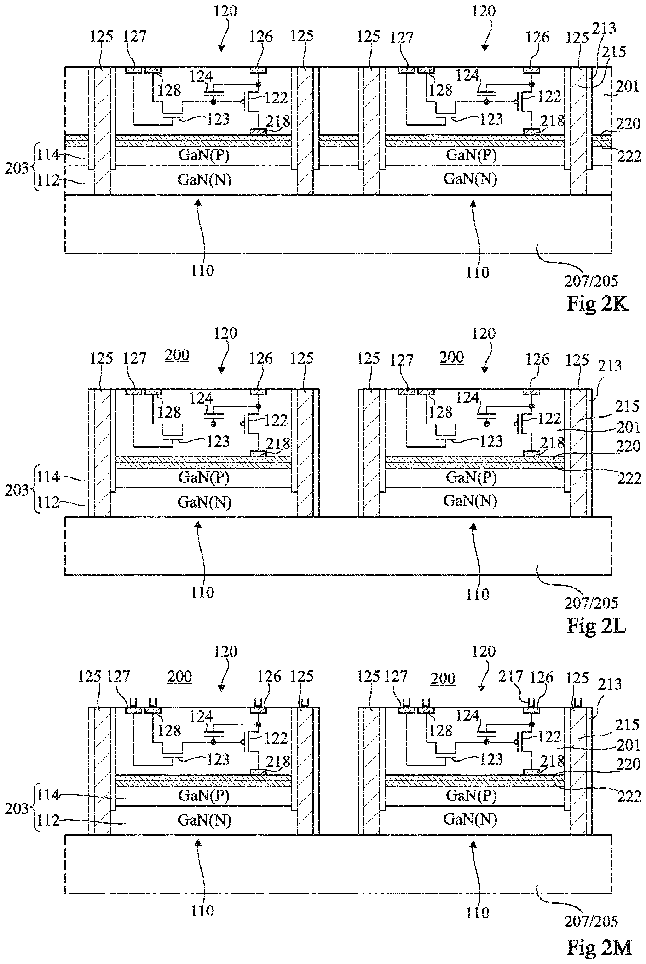

La figure 2K illustre une étape de polissage mécano-chimique (CMP) de la face supérieure de l'assemblage obtenu à l'issue des étapes de la figure 2J, de façon à retirer la couche métallique 215 en dehors des tranchées 209 et en particulier sur la face arrière des circuits de contrôle 120. A l'issue de cette étape, on obtient un assemblage monolithique présentant une face arrière sensiblement plane. Dans chaque micropuce, les plages de connexion électrique 126, 127 et 128 préalablement formées affleurent au niveau de la face arrière ou face de connexion de la micropuce. De plus, chaque micropuce comprend désormais, en plus des plages de connexion électrique 126, 127 et 128, une métallisation annulaire 215 disposée dans la tranchée périphérique 209 de la micropuce, connectée à la couche semiconductrice inférieure 112 de la LED 110 de la micropuce, et isolée de la couche semiconductrice supérieure 114 de la LED et des flancs du circuit de commande 120 par la couche isolante 213. La métallisation annulaire 215 affleure au niveau de la face arrière de la micropuce et constitue la plage de connexion électrique 125 de la micropuce (en reprenant la notation de la figure 1). A ce stade, les plages de connexion électrique 125, 126, 127 et 128 de chaque micropuce sont séparées latéralement par un matériau isolant, par exemple de l'oxyde de silicium.

La figure 2L illustre une étape de découpe du substrat 201, des couches métalliques 220 et 222, et de l'empilement de LED 203 dans des chemins de découpe situés, en vue de dessus, entre les tranchées périphériques 209 des micropuces, de façon à individualiser les micropuces. A titre d'exemple, la découpe des micropuces peut être réalisée par gravure ionique réactive à plasma à couplage inductif, un masque de gravure étant au préalable déposé sur la face supérieure de l'assemblage pour délimiter les chemins de découpe.

A l'issue de cette étape, les micropuces 200 sont entièrement séparées les unes des autres mécaniquement et électriquement, et sont attachées au substrat de support 207 ou au substrat de croissance 205 uniquement par leur face inférieure (côté LED 110).

La figure 2M illustre une étape optionnelle de formation de microstructures conductrices 217 sur la face supérieure des plages de connexion électrique 125, 126, 127 et 128 de chaque micropuce 200, en vue de faciliter la fixation ultérieure des micropuces à un dispositif extérieur. A titre d'exemple, les microstructures 217 sont des microtubes métalliques, par exemple en tungstène, formés par un procédé du type décrit dans la demande de brevet US2011/094789. A titre de variante, les microstructures 217 sont des micropointes du type décrit dans la demande de brevet US2008/190655.

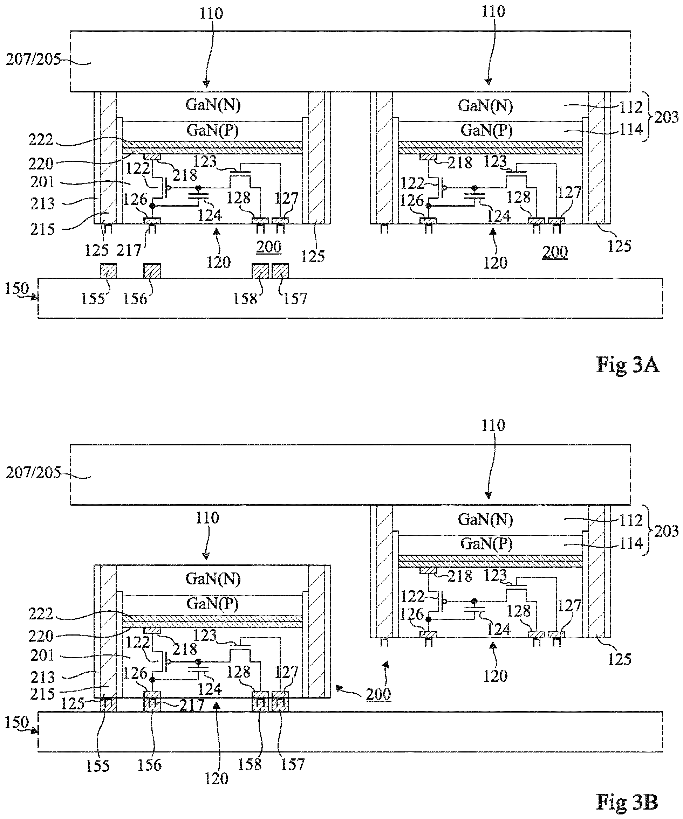

Les figures 3A et 3B sont des vues en coupe illustrant des étapes d'un exemple d'un procédé de fabrication d'un dispositif d'affichage émissif à LED à base de micropuces réalisées par le procédé des figures 2A à 2M.

La figure 3A illustre une étape au cours de laquelle, après avoir formé d'une part les micropuces 200 sur un substrat de support 207 ou 205 par le procédé des figures 2A à 2M, et d'autre part le substrat de report 150, on vient positionner les micropuces 200 en vis-à-vis des zones de report correspondantes du substrat de report 150, faces de connexion des micropuces tournées vers la face de connexion du substrat de report 150, en se servant du substrat de support 207 ou 205 comme poignée.

Les micropuces 200 sont ensuite fixées sur le substrat de report 150, par collage des plages de connexion électrique des micropuces sur les plages de connexion électrique correspondantes du substrat de report (figure 3B). Les micropuces 200 sont ensuite détachées du substrat de support 207 ou 205, et ce dernier est retiré.

En pratique, comme l'illustrent les figures 3A et 3B, le pas des micropuces sur le substrat de support 207 ou 205, par exemple de l'ordre de 10 à 50 µm, peut être inférieur au pas du dispositif final après report sur le substrat 150, par exemple compris entre 15 µm et 1 mm, par exemple de l'ordre de 100 à 500 µm. A titre d'exemple, le pas des micropuces sur le substrat de report 150 est un multiple du pas des micropuces sur le substrat de support 207 ou 205. Ainsi, lors de la réalisation du dispositif d'affichage, on prévoit de reporter seulement une partie des micropuces du substrat de support 207 ou 205 sur le substrat de report 150, au pas du substrat de report 150, puis, si besoin, de décaler le substrat de support avec les micropuces restantes pour reporter une autre partie des micropuces sur le substrat 150, et ainsi de suite jusqu'à ce que toutes les micropuces du dispositif d'affichage aient été fixées sur le substrat 150.

A chaque itération, une fois qu'une ou plusieurs micropuces 200 ont été fixées sur le substrat de report 150, celles-ci sont détachées sélectivement du substrat de support 207 ou 205. Le substrat de support et les micropuces restantes sont ensuite retirés comme illustré par la figure 3B.

Pour détacher sélectivement les micropuces 200 du substrat de support, on peut prévoir un collage faible entre le substrat de support et les micropuces, de façon que seules les micropuces fixées à des plages de connexion électrique du substrat de report 150 soient arrachées lors du retrait du substrat de support, sous l'effet de la force de collage entre les plages de connexion électrique de la micropuce et les plages de connexion électrique du substrat de report.

Dans l'exemple représenté, les plages de connexion électrique 155, 156, 157 et 158 du substrat de report 150 sont en saillie de la face supérieure du substrat de report, de façon que, lors du report, seules les micropuces 200 destinées à être fixées sur le substrat de report soient effectivement mises en contact avec le substrat de report. Ceci permet de faciliter le décollage sélectif des micropuces et le retrait du substrat de support et des micropuces restantes une fois la fixation réalisée.

A titre d'exemple, les micropuces 200 sont collées au substrat de support à l'aide d'un polymère de type C4F8, TEFLON, ou OPTOOL DSX, ou par tout autre adhésif permettant d'obtenir une énergie de collage entre les micropuces 200 et le substrat de support inférieure à l'énergie d'adhérence entre les micropuces et le substrat de report.

A titre de variante, dans le cas où le substrat de support est transparent, le collage des micropuces 200 au substrat de support peut être réalisé par une résine adaptée à être dégradée par un rayonnement ultraviolet. Une insolation laser localisée de la résine peut alors être réalisée au travers du substrat de support, pour détacher sélectivement une partie des micropuces 200.

Dans le cas où le substrat de support est le substrat de croissance des LED 110, ce dernier peut présenter une adhérence relativement forte avec les micropuces 200. Dans ce cas, on peut utiliser un procédé de décollement sélectif au moyen d'un faisceau laser localisé projeté à travers le substrat de support, par exemple un procédé du type décrit dans la demande de brevet US6071795.

Comme indiqué précédemment, les modes de réalisation décrits ne se limitent pas au cas particulier représenté dans lequel des microstructurations sont formées sur les plages de connexion électrique des micropuces. A titre de variante, les plages de connexion électrique des micropuces peuvent être lisses, et la fixation des micropuces sur le substrat de report 150 peut être réalisée par collage direct des plages de connexion électrique des micropuces sur les plages de connexion électrique correspondantes du substrat de support. Une étape de préparation des surfaces de contact des plages de connexion électrique des micropuces et du substrat de report peut éventuellement être prévue préalablement au report, de façon à obtenir une planéité suffisante pour obtenir un collage direct entre les plages de connexion électrique des micropuces et du substrat de report.

On notera de plus que les modes de réalisation décrits ne se limitent pas à l'exemple des figures 3A et 3B dans lequel les plages de connexion électrique du substrat de report sont en saillie de la face de connexion du susbtrat de report. A titre de variante, la face de connexion du substrat de report peut être sensiblement plane comme dans l'exemple de la figure 1.

Un avantage du dispositif d'affichage obtenu par le procédé décrit en relation avec les figures 2A à 2M, 3A et 3B est que chaque micropuce comprend une métallisation annulaire 215 contactant la couche semiconductrice de type N 112 de la LED 110 sur toute la périphérie de la LED. Ceci permet d'améliorer l'injection électrique et donc le rendement lumineux de la LED par rapport à des micropuces du type illustré par la figure 1.

De plus, du fait de la présence des couches métalliques 222 et 220, la couche semiconductrice de type P 114 de la LED 110 est contactée sur toute sa surface opposée à la couche 112. Là encore, ceci permet d'améliorer l'injection électrique et donc le rendement lumineux de la LED par rapport à des micropuces du type illustré par la figure 1.

Par ailleurs, la présence de la métallisation annulaire 215 délimitant latéralement la LED 110 permet d'améliorer la directivité d'émission de la micropuce, et en particulier d'éviter que de la lumière soit émise latéralement en direction des autres micropuces du dispositif.

A cet effet, on notera qu'il est avantageux que, à l'étape décrite en relation avec la figure 2I, après le retrait de la couche isolante 213 sur le fond des tranchées 209, les tranchées 209 soient prolongées jusqu'à la face supérieure du substrat de support 207/205, de façon que les métallisations annulaire 215 se prolongent jusqu'à la face supérieure (dans l'orientation de la figure 3B) ou face d'émission des micropuces. Les modes de réalisation décrits ne se limitent toutefois pas à ce cas particulier. A titre de variante, après le retrait de la couche isolante 213 sur le fond des tranchées 209, les tranchées peuvent être seulement partiellement prolongées (c'est-à-dire sans traverser entièrement la couche semiconductrice 112), ou ne pas être prolongées du tout. La séparation optique inter-pixels assurée par les métallisations 215 sera alors un peu moins efficace, mais la fonction de prise de contact électrique sur la couche semiconductrice 112 restera assurée par les métallisations 215.

Par ailleurs, on notera que dans le procédé de fabrication des micropuces décrit en relation avec les figures 2A à 2M, lors de l'étape de report de l'empilement de LED 203 sur le substrat 201 dans et sur lequel ont été préalablement formés les circuits de commande 120 des micropuces (figure 2C), les positions des différentes LED 110 dans l'empilement 203 ne sont pas encore définies. Il n'y a par conséquent pas de contrainte forte en termes de précision d'alignement lors du report. Ceci constitue un avantage par rapport au procédé décrit dans la demande de brevet français n°1561421 susmentionnée, dans lequel une matrice de LED individualisées et une matrice de circuits de commande élémentaires sont formées séparément, puis reportées l'une sur l'autre, ce qui nécessite un alignement précis lors du report compte tenu des faibles dimensions des micropuces.

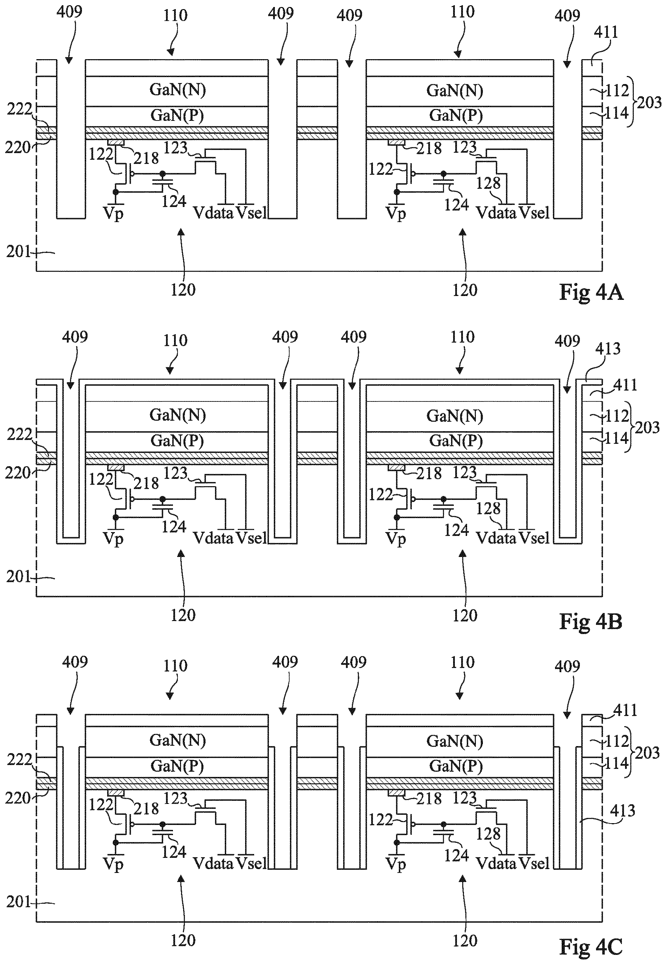

Les figures 4A à 4F sont des vues en coupe illustrant des étapes successives d'un autre exemple d'un procédé de fabrication de micropuces élémentaires 400 d'un dispositif d'affichage émissif à LED selon un mode de réalisation. Le procédé des figures 4A à 4F et les micropuces 400 réalisées par ce procédé comprennent des éléments communs avec le procédé des figures 2A à 2M et avec les micropuces 200 réalisées par le procédé des figures 2A à 2M. Dans la suite, seules les différences entre les deux modes de réalisation seront soulignées.

Les étapes initiales du procédé des figures 4A à 4F sont identiques ou similaires aux étapes décrites précédemment en relation avec les figures 2A à 2D.

La figure 4A illustre une étape dans laquelle, partant de la structure obtenue à l'issue de l'étape de la figure 2D, c'est-à-dire après le retrait du substrat de croissance 205 de l'empilement de LED 203, on réalise, dans chaque micropuce, à partir de la face de l'empilement de LED 203 opposée au circuit de commande 120, c'est-à-dire la face supérieure de l'empilement 203 dans l'orientation de la figure 4A, une tranchée périphérique annulaire 409, entourant entièrement, en vue de dessus, le circuit de commande 120 et la LED 110 de la micropuce. La tranchée 409 s'étend verticalement depuis la face supérieure de l'empilement de LED 203, traverse entièrement l'empilement de LED 203 et les couches métalliques 220 et 222, et pénètre dans le substrat 201 sur une profondeur supérieure ou égale à l'épaisseur finale du circuit de commande 120 de la micropuce 400 (c'est-à-dire au moins jusqu'à la future face de connexion de la micropuce), sans toutefois traverser entièrement le substrat 201. On notera qu'à ce stade, le substrat 201 n'a pas encore été aminci pour former les plages de connexion électrique de la micropuce, et peut servir de poignée de support pour la réalisation des tranchées 409. Les tranchées 409 sont par exemple formées par gravure, par exemple par gravure ionique réactive à plasma à couplage inductif (RIE-ICP). Un masque de gravure 411, par exemple en oxyde de silicium est formé au préalable sur la face supérieure de l'empilement de LED 203 pour délimiter les zones de gravure.

La figure 4B illustre une étape de dépôt conforme d'une couche électriquement isolante 413, par exemple une couche d'oxyde de silicium, sur les parois latérales et sur le fond des tranchées 409. Dans l'exemple représenté, la couche 413 est une couche continue s'étendant sur sensiblement toute la surface supérieure de la structure obtenue à l'issue des étapes de la figure 4A. La couche 413 est par exemple formée par dépôt chimique en phase vapeur assisté par plasma (PECVD) ou par dépôt en couches monoatomiques successives (ALD).

La figure 4C illustre une étape de retrait de la couche isolante 413 sur une partie supérieure des parois latérales des tranchées 409, de façon à libérer l'accès aux flancs de la couche semiconductrice 112 de la LED 110 de chaque micropuce. La couche isolante 413 est en revanche conservée sur la partie inférieure des parois latérales de la tranchée, et en particulier sur les flancs de la couche semiconductrice inférieure 114 de la LED 110 et sur les flancs du circuit de commande 120 de chaque micropuce. Le retrait partiel de la couche isolante 413 est par exemple réalisé au moyen d'un procédé de gravure directionnelle, par exemple par gravure ionique réactive à plasma à couplage inductif, par exemple au moyen d'un plasma fluoré. Lors de cette étape, la couche 413 peut en outre être retirée au fond des tranchées 409 et sur la face supérieure de l'empilement LED, comme représenté en figure 4C. De plus, le masque de gravure 411 peut être retiré. De préférence, on prévoit à cette étape de former ou de conserver une couche isolante de protection sur la face supérieure de l'empilement de LED 203. Dans l'exemple représenté, cette couche de protection est constituée par un résidu du masque de gravure 411.

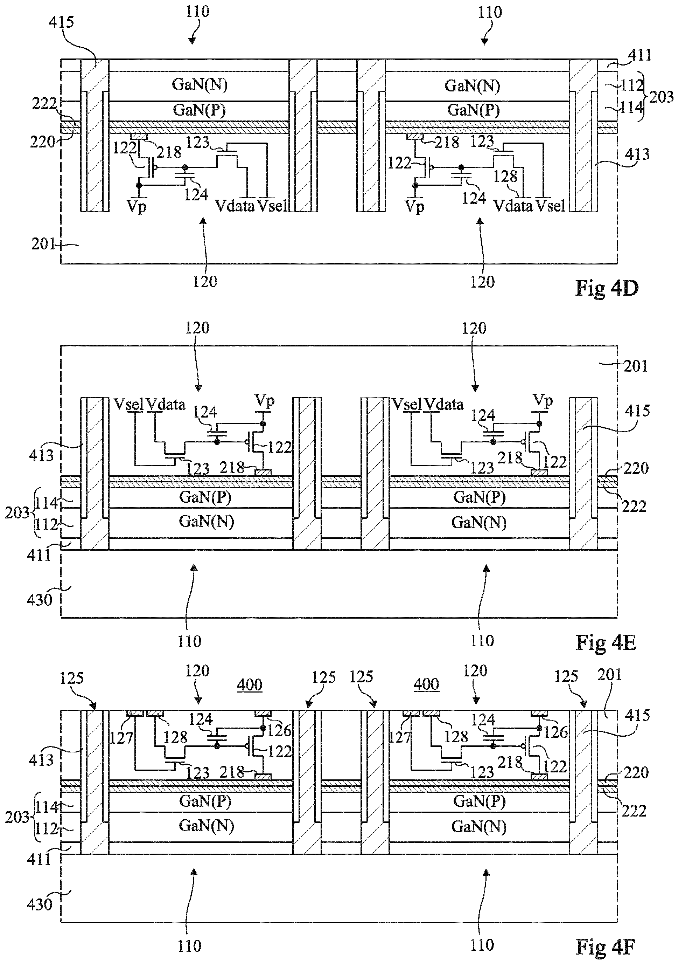

La figure 4D illustre une étape de remplissage des tranchées 409 par un métal conducteur 415, par exemple du cuivre, de façon similaire à ce qui a été décrit en relation avec la figure 2J. Une étape de polissage mécanochimique peut être mise en oeuvre de façon à retirer le métal déposé en dehors des tranchées et à planariser la face supérieure (dans l'orientation de la figure 4D) de la structure, le polissage pouvant par exemple être interrompu sur la face supérieure de la couche isolante 411.

La figure 4E illustre une étape de report de la structure obtenue à l'issue de l'étape de la figure 4D, sur un substrat de support temporaire 430. Lors de cette étape, la face supérieure de la structure de la figure 4D (côté LED) est collée sur une face du substrat de support 430.

La figure 4F illustre une étape de formation des plages de connexion électrique des micropuces 400 du côté de la face arrière du substrat 201, en se servant du substrat de support 430 comme poignée. Lors de cette étape, le substrat 201 est aminci par sa face arrière, par exemple par meulage, jusqu'à atteindre les métallisations 415 préalablement formées dans les tranchées 409. La face arrière de chaque métallisation 415 définit la plage de connexion 125 de la micropuce correspondante. Après amincissement du substrat 201, les plages de connexion contactant des composants du circuit de commande 120 de la micropuce, à savoir les plages de connexion 126, 127 et 128, sont formées sur la face arrière du substrat 201. Les plages de connexion électrique 126, 127, 128 sont par exemple réalisées en métal, par exemple en cuivre. A titre d'exemple, les plages de connexion électrique 126, 127, 128 sont connectées aux composants des circuits de commande 120 par l'intermédiaire de vias conducteurs isolés 126', 127', 128' traversant entièrement le substrat 201 et contactant des métallisations 126", 127", 128" préalablement formées du côté de la face avant du substrat 201, comme l'illustre plus en détail la figure 6.

Les étapes suivantes du procédé sont par exemple identiques ou similaires à ce qui a été décrit précédemment en relation avec les figures 2L, 2M, 3A et 3B (individualisation des micropuces 400 et report sur un substrat de report 150 pour former un dispositif d'affichage).

Des modes de réalisation particuliers ont été décrits. Diverses variantes et modifications apparaîtront à l'homme de l'art. En particulier, l'homme du métier saura adapter les exemples décrits en inversant les types de conductivité des couches semiconductrices 112 et 114 de l'empilement de LED 203.

Par ailleurs, bien que l'on ait décrit uniquement des exemples de réalisation dans lesquels les micropuces reportées sur le substrat de report comportent chacune une LED et un circuit de commande de la LED, les modes de réalisation décrits ne se limitent pas à ce cas particulier. A titre de variante, chaque micropuce peut comporter une pluralité de LED et un circuit actif de commande de la pluralité de LED.

En outre, les modes de réalisation décrits ne se limitent pas aux exemples représentés dans lesquels chaque micropuce comprend quatre plages de connexion électrique.

## Revendications

1. Procédé de fabrication de puces élémentaires (200 ; 400) d'un dispositif d'affichage émissif à LED, chaque puce comprenant une LED semiconductrice inorganique (110), un circuit de commande (120) de la LED, et une pluralité de plages de connexion (125, 126, 127, 128) à un dispositif extérieur disposées sur une face de connexion de la puce, le procédé comportant les étapes suivantes :
a) former les circuits de commande (120) des puces dans et sur un substrat semiconducteur (201) de façon que chaque circuit de commande comporte un plot de contact (218) du côté d'une première face du substrat ;
b) rapporter sur la première face du substrat un empilement de LED (203) comportant au moins des première (112) et deuxième (114) couches semiconductrices de types de conductivité opposés, de façon que la deuxième couche (114) de l'empilement soit électriquement connectée aux plots de contact (218) des circuits de commande ;
c) former dans chaque puce une tranchée périphérique (209 ; 409) entourant, en vue de dessus, le circuit de commande et la LED de la puce, la tranchée périphérique s'étendant verticalement dans le substrat (201) sur toute la hauteur du circuit de commande (120), traversant la deuxième couche semiconductrice (114) de l'empilement de LED, et pénétrant au moins partiellement dans la première couche semiconductrice (112) de l'empilement de LED ;
d) former dans chaque tranchée (209 ; 409) une métallisation annulaire (215 ; 415) en contact avec la première couche semiconductrice (112) de l'empilement de LED sur toute la longueur de la tranchée ; et
e) découper le substrat (201) et l'empilement de LED (203) dans des chemins de découpe situés, en vue de dessus, à l'extérieur des tranchées périphériques des puces de façon à individualiser les puces.

2. Procédé selon la revendication 1, dans lequel, dans chaque puce (200 ; 400) :
la face de la métallisation annulaire (215 ; 415) opposée à la première couche semiconductrice (112) de l'empilement de LED débouche sur une deuxième face du substrat (201) opposée à la première face et définit une première plage de connexion (125) de la puce ; et
au moins une deuxième plage de connexion électrique (126, 127, 128) connectée au circuit de commande (120) de la puce est formée sur la deuxième face du substrat (201).

3. Procédé selon la revendication 2, dans lequel les tranchées (209) sont formées à partir de la deuxième face du substrat (201), après la formation de ladite au moins une deuxième plage de connexion électrique (126, 127, 128).

4. Procédé selon la revendication 3, dans lequel les tranchées (209) traversent entièrement le substrat (201) et la deuxième couche semiconductrice (114) de l'empilement de LED (203), et s'interrompent dans la première couche semiconductrice (112) de l'empilement de LED.

5. Procédé selon la revendication 4, comprenant, entre l'étape c) et l'étape d), une étape de dépôt conforme d'une couche isolante (213) sur les parois latérales et sur le fond des tranchées (209), et une étape de retrait de ladite couche isolante (213) au fond des tranchées (209) pour libérer l'accès à la première couche semiconductrice (112) de l'empilement de LED.

6. Procédé selon la revendication 2, dans lequel les tranchées (409) sont formées à partir de la face de l'empilement de LED (203) opposée au substrat (201), avant la formation de ladite au moins une deuxième plage de connexion électrique (126, 127, 128).

7. Procédé selon la revendication 6, dans lequel les tranchées (409) traversent entièrement l'empilement de LED (203), et pénètrent dans le substrat (201) sur une profondeur supérieure ou égale à l'épaisseur du circuit de commande (120).

8. Procédé selon la revendication 7, comprenant, entre l'étape c) et l'étape d), une étape de dépôt conforme d'une couche isolante (413) sur les parois latérales et sur le fond des tranchées (409), et une étape de retrait de ladite couche isolante (413) sur une partie supérieure des parois latérales des tranchées (409), pour libérer l'accès à la première couche semiconductrice (112) de l'empilement de LED.

9. Procédé selon l'une quelconque des revendications 1 à 8, comprenant en outre, avant l'étape a), une étape de dépôt d'une première couche métallique (220) s'étendant de façon continue sur sensiblement toute la première face du substrat (201), et une étape de dépôt d'une deuxième couche métallique (222) s'étendant de façon continue sur sensiblement toute la surface de la deuxième couche semiconductrice (114) de l'empilement de LED (203) opposée à la première couche semiconductrice (112) dudit empilement.

10. Procédé selon la revendication 9, dans lequel, à l'étape b), la fixation de l'empilement de LED (203) sur le substrat (201) est réalisée par collage direct de la première couche métallique (220) sur la deuxième couche métallique (222).

11. Procédé de fabrication d'un dispositif d'affichage émissif à LED, comprenant les étapes suivantes :
réaliser une pluralité de puces élémentaires (200 ; 400) par un procédé selon l'une quelconque des revendications 1 à 10 ;
réaliser un substrat de report (150) comprenant, pour chaque puce (200 ; 400), sur une face de connexion du substrat de report, une pluralité de plages de connexion destinées à être connectées respectivement aux plages de connexion de la puce ; et
fixer les puces (200 ; 400) sur le substrat de report de façon à connecter électriquement les plages de connexion des puces sur les plages de connexion correspondantes du substrat de report.

12. Procédé selon la revendication 11, dans lequel, à l'issue de l'étape e), les puces (200 ; 400) sont disposées sur un substrat de support (207, 205 ; 430) selon un pas inter-puces inférieur au pas inter-puces du dispositif d'affichage final ; et
seule une partie des puces du substrat de support sont fixées au substrat de report au pas du dispositif d'affichage final et sont sélectivement détachées du substrat de support.

13. Puce élémentaire (200 ; 400) d'un dispositif d'affichage émissif à LED, comprenant une LED semiconductrice inorganique (110), un circuit de commande (120) de la LED, et une pluralité de plages de connexion (125, 126, 127, 128) à un dispositif extérieur, dans laquelle :
le circuit de commande (120) est formé dans et sur un substrat semiconducteur et comprend un plot de contact (218) du côté d'une première face du substrat (201) ;
la LED (110) est formée dans un empilement de LED (203) comportant au moins des première (112) et deuxième (114) couches semiconductrices de types de conductivité opposés, la deuxième couche (114) de l'empilement étant électriquement connectée au plot de contact (218) du circuit de commande ;
au moins une tranchée périphérique (209 ; 409) entoure, en vue de dessus, le circuit de commande (120) et la LED (110) de la puce, la tranchée annulaire s'étendant verticalement sur toute la hauteur du circuit de commande (120), traversant la deuxième couche semiconductrice (114) et pénétrant au moins partiellement dans la première couche semiconductrice (112) de l'empilement de LED ; et
une métallisation annulaire (215 ; 415) disposée dans la tranchée annulaire est en contact avec la première couche semiconductrice (112) de l'empilement de LED sur toute la longueur de la tranchée.

14. Puce selon la revendication 13, dans laquelle un empilement de première (220) et deuxième (222) couches métalliques s'étendant sur sensiblement toute la surface du circuit de commande (120) fait interface entre le circuit de commande (120) et la LED (110) de la puce.

15. Dispositif d'affichage émissif à LED comprenant :
une pluralité de puces élémentaires (200 ; 400) selon la revendication 13 ou 14 ; et
un substrat de report (150) comprenant, pour chaque puce (200 ; 400), sur une face de connexion du substrat de report, une pluralité de plages de connexion connectées respectivement aux plages de connexion de la puce.

## Patentansprüche

1. Verfahren zur Herstellung von Elementarchips (200; 400) einer LED-basierten, emissiven Displayeinrichtung, wobei jeder Chip Folgendes aufweist:
eine anorganische Halbleiter LED (110), eine Schaltung (120) zum Steuern der LED, und eine Vielzahl von Verbindungsbereichen (125, 126, 127, 128) zu einer externen Einrichtung, die auf einer Verbindungsoberfläche des Chips angeordnet ist, wobei das Verfahren folgende Schritte aufweist:
a) Bilden der Steuerschaltungen (120) der Chips innerhalb und auf einem Halbleitersubstrat (201), so dass jede Steuerschaltung ein Kontaktpad (218) auf der Seite einer ersten Oberfläche von dem Substrat aufweist;
b) Übertragen eines LED-Stapels (203) auf die erste Oberfläche des Substrates, wobei der LED-Stapel mindestens erste (112) und zweite (114) Halbleiterschichten entgegengesetzter Leitfähigkeitstypen aufweist, so dass die zweite Schicht (114) des Stapels elektrisch mit den Kontaktpads (218) der Steuerschaltungen verbunden ist;
c) Bilden einer peripheren Furche (209; 409) in jedem Chip, der, in Draufsicht, die Steuerschaltung und die LED des Chips umgibt, wobei sich die periphere Furche vertikal in das Substrat (201) entlang der gesamten Höhe der Steuerschaltung (120) erstreckt, wobei sie die zweite Halbleiterschicht (114) des LED-Stapels kreuzt, und wobei sie zumindest teilweise in die erste Halbleiterschicht (112) des LED-Stapels eindringt;
d) Bilden, in jeder Furche (209; 409), einer ringförmigen Metallisierung (215; 415) in Kontakt mit der ersten Halbleiterschicht (112) des LED-Stapels entlang der gesamten Länge der Furche; und
e) Schneiden des Substrats (201) und des LED-Stapels (203) entlang von Schneidewegen, die, in Draufsicht, außerhalb der peripheren Furchen der Chips liegen, um die Chips zu individualisieren.

2. Das Verfahren nach Anspruch 1, wobei, in jedem Chip (200; 400):
die Oberfläche der ringförmigen Metallisierung (215; 415) gegenüber der ersten Halbleiterschicht (112) des LED-Stapels auf eine zweite Oberfläche des Substrats (201) hervortritt, die gegenüber der ersten Oberfläche liegt und die einen ersten Verbindungsbereich (125) des Chips definiert; und
wobei mindestens ein zweiter elektrischer Verbindungsbereich (126, 127, 128), der mit der Steuerschaltung (120) des Chips verbunden ist, auf der zweiten Oberfläche des Substrats (201) gebildet wird.

3. Das Verfahren nach Anspruch 2, wobei die Furchen (209) von der zweiten Oberfläche des Substrats (201) gebildet werden, und zwar nach dem Bilden des mindestens einen zweiten elektrischen Verbindungsbereichs (126, 127, 128).

4. Das Verfahren nach Anspruch 3, wobei die Furchen (209) das Substrat (201) und die zweite Halbleiterschicht (114) des LED-Stapels (203) durchgängig kreuzen und in der ersten Halbleiterschicht (112) des LED-Stapels unterbrochen werden.

5. Das Verfahren nach Anspruch 4, das Folgendes aufweist:
zwischen Schritt c) und Schritt d), einen Schritt zu konformem Ablagern bzw. Abscheiden einer Isolierschicht (213) auf den Seitenwänden und auf dem Grund der Furchen (209), und
einen Schritt zum Entfernen der Isolierschicht (213) vom Grund der Furchen (209), um den Zugang zur ersten Halbleiterschicht (112) des LED-Stapels freizulegen.

6. Das Verfahren nach Anspruch 2, wobei die Furchen (409) von der Oberfläche des LED-Stapels (203) gegenüber dem Substrat (201) gebildet werden, und zwar vor dem Bilden des mindestens einen zweiten elektrischen Verbindungsbereichs (126, 127, 128).

7. Das Verfahren nach Anspruch 6, wobei die Furchen (409) den LED-Stapel (203) durchgängig kreuzen und in das Substrat (201) bis zu einer Tiefe endringen, die größer oder gleich der Dicke der Steuerschaltung (120) ist.

8. Das Verfahren nach Anspruch 7, das Folgendes aufweist:
zwischen Schritt c) und Schritt d), einen Schritt zu konformem Ablagern bzw. Abscheiden einer Isolierschicht (413) auf den Seitenwänden und auf dem Grund der Furchen (409), und einen Schritt zum Entfernen der Isolierschicht (413) von einem oberen Teil der Seitenwände der Furchen (409), um den Zugang zur ersten Halbleiterschicht (112) des LED-Stapels freizulegen.

9. Das Verfahren nach einem der Ansprüche 1 bis 8, das weiterhin Folgendes aufweist:
vor Schritt a), einen Schritt zum Ablagern bzw. Abscheiden einer ersten Metallschicht (220), die sich kontinuierlich über im Wesentlichen die gesamte erste Oberfläche des Substrats (201) erstreckt, und einen Schritt zum Ablagern einer zweiten Metallschicht (222), die sich kontinuierlich über im Wesentlichen die gesamte Oberfläche der zweiten Halbleiterschicht (114) des LED-Stapels (203) gegenüber der ersten Halbleiterschicht (112) des Stapels erstreckt.

10. Das Verfahren nach Anspruch 9, wobei, bei Schritt b), das Befestigen des LED-Stapels (203) auf dem Substrat (201) mittels direkter Verbindung der ersten Metallschicht (220) auf die zweite Metallschicht (222) ausgeführt wird.

11. Verfahren zur Herstellung einer LED-basieren, emissiven Displayeinrichtung, die folgende Schritte aufweist:
Bilden einer Vielzahl von Elementarchips (200; 400) mittels des Verfahrens nach einem der Ansprüche 1 bis 10;
Bilden eines Transfersubstrates (150), das für jeden Chip (200; 400) auf einer Verbindungsoberfläche des Transfersubstrats eine Vielzahl von Verbindungsbereichen aufweist, die dafür vorgesehen sind, entsprechend mit den Verbindungsbereichen des Chips verbunden zu werden; und
Befestigen der Chips (200; 400) auf dem Transfersubstrat, um die Chipverbindungsbereiche elektrisch mit den entsprechenden Verbindungsbereichen des Transfersubstrats zu verbinden.

12. Das Verfahren nach Anspruch 11, wobei, am Ende von Schritt e), die Chips (200; 400) auf einem Trägermaterial (207, 205; 430) angeordnet werden, und zwar mit einem Abstand zwischen den Chips, der kleiner als der Abstand zwischen Chips der finalen Displayeinrichtung ist; und
wobei nur ein Teil der Chips des Trägersubstrats am Transfersubstrat am Abstand der finalen Displayeinrichtung befestigt und selektiv losgelöst vom Trägermaterial ist.

13. Elementarchip (200; 400), einer LED-basierten, emissiven Displayeinrichtung, wobei jeder Chip Folgendes aufweist:
eine anorganische Halbleiter-LED (110), eine Schaltung (120) zum Steuern der LED, und eine Vielzahl von Verbindungsbereichen (125, 126, 127, 128) zu einer externen Einrichtung, wobei die Steuerungsschaltung (120) innerhalb und auf einem Halbleitersubstrat gebildet ist und ein Kontaktpad (218) auf der Seite einer ersten Oberfläche des Substrats (201) aufweist;
wobei die LED (110) in einem LED-Stapel (203) gebildet ist, der mindestens erste (112) und zweite (114) Halbleiterschichten entgegengesetzter Leitfähigkeitstypen aufweist, so dass die zweite Schicht (114) des Stapels elektrisch mit den Kontaktpads (218) der Steuerschaltung verbunden ist;
wobei mindestens eine periphere Furche (209; 409), in Draufsicht, die Steuerschaltung (120) und die LED (110) des Chips umgibt, wobei sich die ringförmige Furche vertikal entlang der gesamten Höhe der Steuerschaltung (120) erstreckt, wobei sie die zweite Halbleiterschicht (114) kreuzt, und wobei sie zumindest teilweise in die erste Halbleiterschicht (112) des LED-Stapels eindringt; und
wobei eine ringförmige Metallisierung (215; 415) in der ringförmigen Furche in Kontakt mit der ersten Halbleiterschicht (112) des LED-Stapels entlang der gesamten Länge der Furche angeordnet ist.

14. Der Chip nach Anspruch 13, wobei ein Stapel von ersten (220) und zweiten (222) Metallschichten, der sich über im Wesentlichen die gesamte Oberfläche der Steuerungsschaltung (120) erstreckt, eine Schnittstelle zwischen der Steuerungsschaltung (120) und der LED (110) des Chips bildet.

15. LED-basierte, emissive Displayeinrichtung, die Folgendes aufweist:
eine Vielzahl von Elementarchips (200; 400) nach Anspruch 13 oder 14; und
ein Transfersubstrat (150), das, für jeden Chip (200; 400), auf einer Verbindungsoberfläche des Transfersubstrats, eine Vielzahl von Verbindungsbereichen aufweist, die entsprechend mit den Verbindungsoberflächen des Chips verbunden sind.

## Claims

1. A method of manufacturing elementary chips (200; 400) of a LED-based emissive display device, each chip comprising an inorganic semiconductor LED (110), a circuit (120) for controlling the LED, and a plurality of areas (125, 126, 127, 128) of connection to an external device arranged on a connection surface of the chip, the method comprising the steps of:
a) forming the control circuits (120) of the chips inside and on top of a semiconductor substrate (201) so that each control circuit comprises a contact pad (218) on the side of a first surface of the substrate;
b) transferring onto the first surface of the substrate a LED stack (203) comprising at least first (112) and second (114) semiconductor layers of opposite conductivity types, so that the second layer (114) of the stack is electrically connected to the contact pads (218) of the control circuits;
c) forming in each chip a peripheral trench (209; 409) surrounding, in top view, the control circuit and the LED of the chip, the peripheral trench extending vertically in the substrate (201) along the entire height of the control circuit (120), crossing the second semiconductor layer (114) of the LED stack, and at least partially penetrating into the first semiconductor layer (112) of the LED stack;
d) forming in each trench (209; 409) a ring-shaped metallization (215; 415) in contact with the first semiconductor layer (112) of the LED stack along the entire length of the trench; and
e) cutting the substrate (201) and the LED stack (203) along cutting paths located, in top view, outside of the peripheral trenches of the chips to individualize the chips.

2. The method of claim 1, wherein, in each chip (200; 400) :
the surface of the ring-shaped metallization (215; 415) opposite to the first semiconductor layer (112) of the LED stack emerges onto a second surface of the substrate (201) opposite to the first surface and defines a first connection area (125) of the chip; and
at least one second electric connection area (126, 127, 128) connected to the control circuit (120) of the chip is formed on the second surface of the substrate (201).

3. The method of claim 2, wherein the trenches (209) are formed from the second surface of the substrate (201), after the forming of said at least one second electric connection area (126, 127, 128).

4. The method of claim 3, wherein the trenches (209) thoroughly cross the substrate (201) and the second semiconductor layer (114) of the LED stack (203) and are interrupted in the first semiconductor layer (112) of the LED stack.

5. The method of claim 4, comprising, between step c) and step d), a step of conformal deposition of an insulating layer (213) on the lateral walls and on the bottom of the trenches (209), and a step of removing said insulating layer (213) from the bottom of the trenches (209) to free the access to the first semiconductor layer (112) of the LED stack.

6. The method of claim 2, wherein the trenches (409) are formed from the surface of the LED stack (203) opposite to the substrate (201), before the forming of said at least one second electric connection area (126, 127, 128).

7. The method of claim 6, wherein the trenches (409) thoroughly cross the LED stack (203) and penetrate into the substrate (201) down to depth greater than or equal to the thickness of the control circuit (120).

8. The method of claim 7, comprising, between step c) and step d), a step of conformal deposition of an insulating layer (413) on the lateral walls and on the bottom of the trenches (409), and a step of removing said insulating layer (413) from an upper portion of the lateral walls of the trenches (409) to free the access to the first semiconductor layer (112) of the LED stack.

9. The method of any of claims 1 to 8, further comprising, before step a), a step of depositing a first metal layer (220) continuously extending over substantially the entire first surface of the substrate (201) and a step of depositing a second metal layer (222) continuously extending over substantially the entire surface of the second semiconductor layer (114) of the LED stack (203) opposite to the first semiconductor layer (112) of said stack.

10. The method of claim 9, wherein, at step b), the affixing of the LED stack (203) onto the substrate (201) is performed by direct bonding of the first metal layer (220) to the second metal layer (222).

11. A method of manufacturing a LED-based emissive display device, comprising the steps of:
forming a plurality of elementary chips (200; 400) by the method of any of claims 1 to 10;
forming a transfer substrate (150) comprising, for each chip (200; 400), on a connection surface of the transfer substrate, a plurality of connection areas intended to be respectively connected to the connection areas of the chip; and
affixing the chips (200; 400) onto the transfer substrate to electrically connect the chip connection areas to the corresponding connection areas of the transfer substrate.

12. The method of claim 11, wherein, at the end of step e), the chips (200; 400) are arranged on a support substrate (207, 205; 430) with a pitch between chips smaller than the pitch between chips of the final display device; and
only part of the chips of the support substrate are affixed to the transfer substrate at the pitch of the final display device and are selectively detached from the support substrate.

13. An elementary chip (200; 400) of a LED-based emissive display device, comprising an inorganic semiconductor LED (110), a circuit (120) for controlling the LED, and a plurality of areas (125, 126, 127, 128) of connection to an external device, wherein:
the control circuit (120) is formed inside and on top of a semiconductor substrate and comprises a contact pad (218) on the side of a first surface of the substrate (201);
the LED (110) is formed in a LED stack (203) comprising at least first (112) and second (114) semiconductor layers of opposite conductivity types, the second layer (114) of the stack being electrically connected to the contact pad (218) of the control circuit;
at least one peripheral trench (209; 409) surrounds, in top view, the control circuit (120) and the LED (110) of the chip, the ring-shaped trench extending vertically along the entire height of the control circuit (120), crossing the second semiconductor layer (114), and at least partially penetrating into the first semiconductor layer (112) of the LED stack; and
a ring-shaped metallization (215; 415) arranged in the ring-shaped trench is in contact with the first semiconductor layer (112) of the LED stack all along the trench length.

14. The chip of claim 13, wherein a stack of first (220) and second (222) metal layers extending over substantially the entire surface of the control circuit (120) forms an interface between the control circuit (120) and the LED (110) of the chip.

15. A LED-based emissive display device comprising:
a plurality of elementary chips (200; 400) of claim 13 or 14; and
a transfer substrate (150) comprising, for each chip (200; 400), on a connection surface of the transfer substrate, a plurality of connection areas respectively connected to the connection areas of the chip.
